Europäisches Patentamt

(19) European Patent Office

Office européen des brevets

(11) Publication number: **0 084 247**
**B1**

(12) **EUROPEAN PATENT SPECIFICATION**

(45) Date of publication of patent specification: **04.03.87**

(21) Application number: **82306835.8**

(22) Date of filing: **21.12.82**

(51) Int. Cl.⁴: **G 06 F 1/00,** G 06 F 3/05

(54) **Operation mode setting circuitry for microprocessor.**

(30) Priority: **29.12.81 JP 213710/81**

(43) Date of publication of application:
**27.07.83 Bulletin 83/30**

(45) Publication of the grant of the patent:
**04.03.87 Bulletin 87/10**

(84) Designated Contracting States:
**DE FR GB**

(56) References cited:

**IBM TECHNICAL DISCLOSURE BULLETIN, vol.
23, no. 7A, December 1980, pages 2934-2936,
New York, US J.P. DAHL et al.: "OP code
reconfiguration of keyboard operations"**

**TOUTE L'ELECTRONIQUE, no. 456, August-
September 1980, pages 53-55, Paris, FR C.
VERBEEK: "Module d'acquisition de données
réalisé avec un registre à approximations
successives"**

**IBM TECHNICAL DISCLOSURE BULLETIN, vol.
23, no. 8, January 1981, pages 3613-3614, New
York, US J.E. ROHEN: "Multi-code scanner"**

(73) Proprietor: **FUJITSU LIMITED
1015, Kamikodanaka Nakahara-ku
Kawasaki-shi Kanagawa 211 (JP)**

(72) Inventor: **Murakami, Joji c/o FUJITSU LIMITED
Patent Department 1015 Kamikodanaka
Nakahara-ku
Kawasaki-shi Kanagawa 211 (JP)**

(74) Representative: **Sunderland, James Harry et al
HASELTINE LAKE & CO Hazlitt House
28 Southampton Buildings Chancery Lane
London WC2A 1AT (GB)**

(56) References cited:
**ELECTRONICS, vol. 52, no. 20, September 27,
1979, pages 38-39, New York, US WILLIAM F.
ARNOLD: "Three-level addressing compresses
bits to overcome package pin limitations"**

**ELECTRONIC DESIGN, vol. 29, no. 7, March 31,
1981, pages 161-168, Waseca, MN, Denville,
NJ, US H. GEE et al.: "Signal processor
'digitizes' analog design problems"**

## Description

The present invention relates to operation mode setting circuitry for a microprocessor.

As microprocessors have progressed, their applications have widened. Systems employing them have come to have multifarious variations. In this context there is a demand, to meet users' needs, for a capability for changes to be made in, for example, I/O characteristics, memory maps, or the polarities of certain signal lines, by means of simple modifications, whilst fundamental functions are retained.

On the other hand, it is favourable with regard to the reliability and cost of devices themselves to mass-produce IC's especially LSI IC's such as microprocessors, by the use of the same mask pattern.

In this light, at present the following three measures are proposed in order to cope with user's extended needs as mentioned above;

(1) Only specified masks are partly and simply modified, thereby to provide for variations or changes as mentioned above (the so-called master slice method).

(2) External devices are selected on a system on the user side. In some cases, such external devices are separately prepared as peripheral devices by the manufacturer.

(3) Several pins of a device are used for assigning specific operation modes, and the device is instructed to start one of the several available operation modes through inputs to the pins.

Microprocessors presently available are so constructed that they can operate in various operation modes, for example configured with various I/O characteristics, a plurality of internal and external memory maps, the selection of the polarities of certain signal lines or the use of a test mode or a user mode. These modes are externally set by delivering two-valued logic signals through the pinis of an integrated circuit chip which constructs the microprocessor. The number of the pins available for such use in setting operation modes is limited because a large number of pins are required to allow the microprocessor to perform its functions other than operation mode setting. For this reason, the number of the pins for setting the operation modes has been curtailed.

The expedients mentioned above have been found still to be unsatisfactory, particularly when a comparatively large number of operation modes need to be set, and improvements have been desired.

More precisely, referring back to the aforementioned measures specifically, method (1) results in a need to prepare masks individually. Moreover, the functions which can be changed by the specified masks are still limited. With method (2), the user requires the peripheral devices. This poses problems in terms of cost and reliability. Method (3) is thought to be best. It incurs no problem when the IC has surplus pins, but the number of pins is usually limited.

There will now be described a previously proposed system wherein operation modes are determined by two-valued logic signals supplied to a microprocessor.

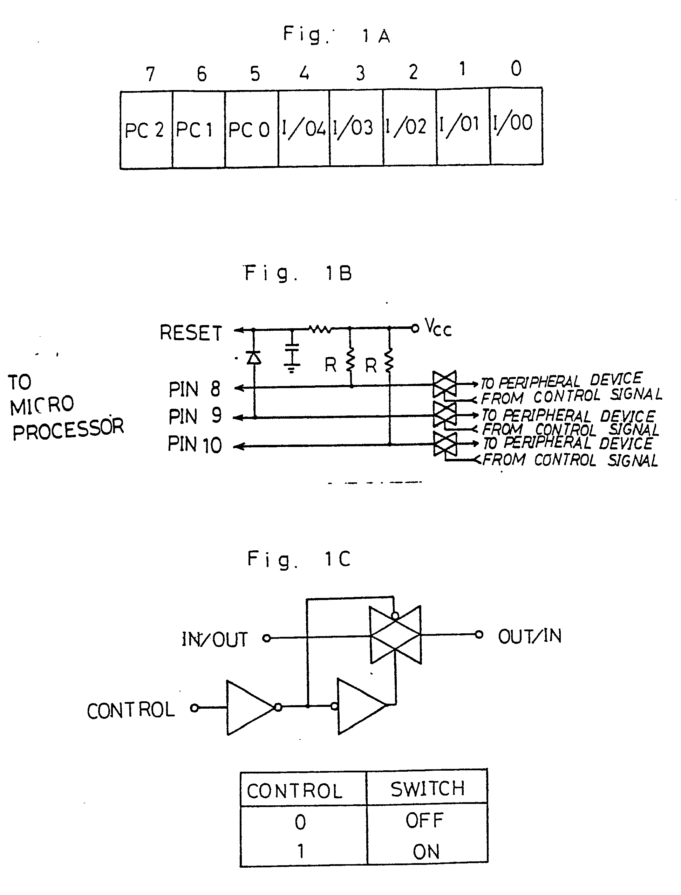

An I/O port register built into a microprocessor is shown schematically in Figure 1A of the accompanying drawings by way of example. It is assumed here that the three upper bits — bits 7, 6 and 5 — of the register are used for setting operation modes. An example of an external circuit in the bus separable extension mode is shown in Figure 1B of the accompanying drawings. The logical values of pins 10, 9 and 8 in Fig. 1B are respectively stored into bits 7, 6 and 5 of the I/O port register of Fig. 1A. Thus, the operation modes are set.

In the reset status, the pins 10, 9 and 8 of the microprocessor are respectively programmed to have logical values "1", "0" and "1" as illustrated in Figure 1B. In a case in which the pins 8—10 are wired to peripheral circuitry and where at the turn-on of a power supply, the peripheral circuitry requires signals different from the signals necessary for mode programming, switching is needed as shown in Figure 1B and a circuit shown in Figure 1C of the accompanying drawings is used for separating the peripheral circuit and the microprocessor during the reset period.

The operation modes after resetting must be determined by the user wiring the pins 10, 9 and 8 externally in hardware fashion. The signals of the three pins are latched in the program control bits PC2, PC1 and PC0 of the I/O port register in Figure 1A when the reset signal becomes "H" level.

The circuit of Figure 1B can be operated in various modes by latching the values of the pins 8, 9 and 10 at the leading edge of a $\overline{RESET}$ signal.

By way of example, in a case where the processor has four I/O ports, I/O1, I/O2, I/O3, I/O4 the following modes are possible:— all the ports function as I/O ports (single chip mode); the ports I/O1 and I/O2 function as I/O ports, port I/O3 functions as a data bus, and port I/O4 as a lower bit address bus or a part thereof (bus separable extension mode); the ports I/O1 and I/O2 function as I/O ports, port I/O3 receives and delivers a lower bit address and data in the time-sharing fashion, and port I/O4 delivers an upper bit address (bus time-sharing extension mode). In this latter mode, the address space of a memory can be enlarged. That is, the largest utilizable address space is given by the bus time-sharing extension mode.

In this manner, in the prior art operation modes habe been set using two-valued logic signals and by means of external circuity, with the disadvantage that a large number of pins may be required for mode setting.

An expedient for reducing the number of pins required solely for setting operation modes is to use input/output pins in common. In this case, the pins must be partitioned in accordance with the change-over of the operation modes. The partitioning inevitably brings about a drawback in that the input/output electrical characteristics of the mode input pin circuity suffer changes.

According to the present invention there is provided operation mode setting circuity for a microprocessor operable in any one of a plurality of operation modes, the operation mode setting circuitry comprising:

a terminal for receiving a multi-valued logic analog voltage the voltage level of which serves for designating one of the said plurality of operation modes;

an analog to digital converter, connected to the said terminal, for converting the voltage level of the analog voltage into a corresponding digital signal; and

a decoder means connected to said analog to digital converter for decoding the digital signal and for generating therefrom a signal for setting the microprocessor or in that one of the operation modes corresponding to the voltage level of the analog voltage.

An embodiment of the present invention can provide for the setting of various operation modes in multivalued logic by the use of analog signals.

An embodiment of the present invention can avoid the disadvantages of the prior art as described above, and can provide an operation mode setting system for a microprocessor which can set any desired number of operation modes on the basis of multi-valued logic by applying analog input signals through a single input pin, without incurring changes in input/output electrical characteristics, etc.

In an embodiment of the present invention an analog signal for specifying an operation mode is converted into a digital value by an analog-to-digital converter circuit, the digital value is decoded by a decoder, and microprocessor is set at the predetermined operation mode in response to the decoded output of the decoder.

Reference is made, by way of example, to the accompanying drawings, in which:—

Figure 1A is a schematic diagram illustrating an I/O port register;

Figure 1B schematically illustrates a previously proposed circuit for setting operation modes;

Figure 1C schematically illustrates a circuit previously proposed for separating a processor and a peripheral circuit;

Figure 2 is a schematic block diagram illustrating an embodiment of the present invention;

Figure 3 is a waveform diagram for assistance in explanation of setting of an operation mode in the embodiment of Figure 2;

Figure 4 is a diagram illustrating a relationship between analog voltages and digital values;

Figure 5 comprises schematic diagrams showing the joint use of external ROMs and RAMs; and

Figure 6 is a memory map of an embodiment of the present invention.

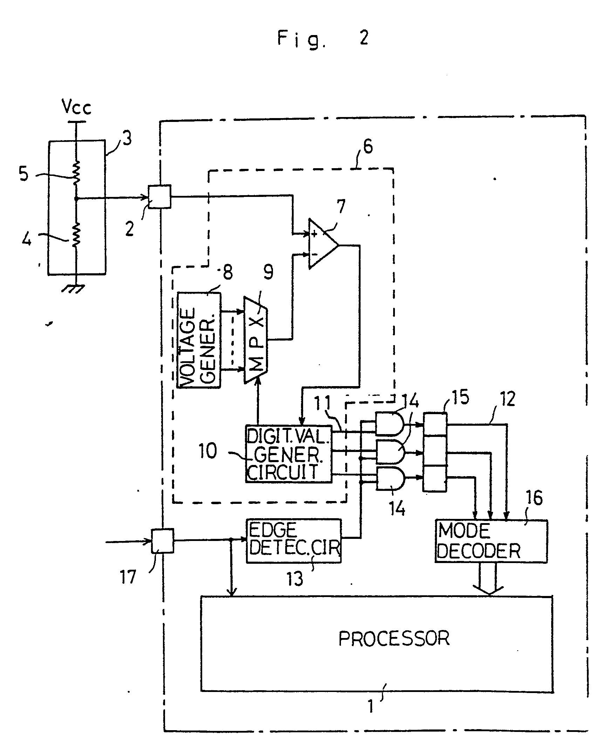

Figure 2 illustrates an embodiment of the present invention. Enclosed with a dot-and-dash line is a microprocessor which is integrated on an identical (single) semiconductor substrate. 1 is a processor portion of the microprocessor, which is so constructed that it can operate in any of a plurality of operation modes. 2 is a mode input pin, to which is connected signal generator circuit means 3 for generating an analog voltage signal for specifying a particular operation mode. The circuit means 3 is for example, a voltage divider circuit comprising resistors 4 and 5. The voltage to be applied to the mode input pin 2 is determined by the voltage division ratio of the resistors 4 and 5.

The mode input pin 2 is connected to an analog-to-digital converter circuit 6, bounded by the broken line in Fig. 2, of the sequential comparison type.

In this regard, an internal type analog-to-digital converter is usually complicated in arrangement and involves a relatively large quantity of hardware to be package along with the processor portion within one chip. Though slow in operation, the sequential comparison type analog-to-digital converter, including only a small quantity of hardware, is satisfactory for setting the operation mode. In the embodiment of Figure 2, accordingly, the use of a sequential comparison type analog-to-digital converter will be explained. However, the integral type analog-to-digital converter as known, for example, from Electronic Design, Vol. 29, No. 7, March 1981, pages 161—168 and other analog-to-digital converters, can alternatively be used in embodiments of the present invention.

The analog-to-digital converter circuit 6 comprises a comparator circuit 7, one input of which is connected to the mode input pin 2, a voltage generator 8, a multiplexer 9, the inputs of which are connected to the outputs of the voltage generator 8 and the output of which is connected to the other input of the comparator circuit 7, and a digital value generator circuit 10 which, in response to an output signal from the comparator circuit 7, generates a digital value and supplies a voltage switching signal to the multiplexer 9.

Bit output lines 11 of the digital value generator circuit 10 are connectd to AND gate circuits 14. Each of the AND gate circuits 14 has a corresponding bit output line 11 connected to one input thereof and has connected to the other input thereof the output of an edge detector circuit 13 to be described later. A mode register 15 has its inputs connected to the outputs of the AND gate circuits, and a mode decoder 16 has its inputs connected to output lines 12 of the mode register 15. The output of the mode decoder 16 is connected to the processor portion 1.

The input of the edge detector circuit 13 is connected to a reset input pin 17, which is also connected to the processor portion 1.

Operations of the embodiment of the present invention illustrated in Fig. 2 will now be described.

Before operating the processor portion 1 in a particular operation mode, an analog voltage signal corresponding to the particular operation mode is generated by the signal generator circuit means 3, and this signal is supplied to and digitized by the analog-to-digital converter circuit 6. The digitization is executed in the following manner. The analog voltage signal is compared by the comparator circuit 7 with a reference voltage which has been obtained in such a way that one of a plurality of voltages provided from the voltage generator 8 is selected by the multiplexer 9. The voltages supplied from the voltage generator 8 differ one from another by incremental voltage differences. An output signal is provided from the comparator circuit 7 unless the analog voltage signal and the voltage provided from the voltage generator coincide. In response to such an output signal, the digital value generator circuit 10 is caused to count up its digital (binary) value by 1 and supplies a voltage switching signal to the multiplexer 9 so as to cause the comparator circuit 7 to be fed with a voltage, from the voltage generator, which is on incremental voltage difference higher than the previously supplied voltage. The digital value stored in the digital value generator circuit 10 when coincidence of the analog voltage signal and the voltage supplied to the comparator circuit 7 from the voltage generator 8 is achieved is a digital equivalent of the analog voltage signal.

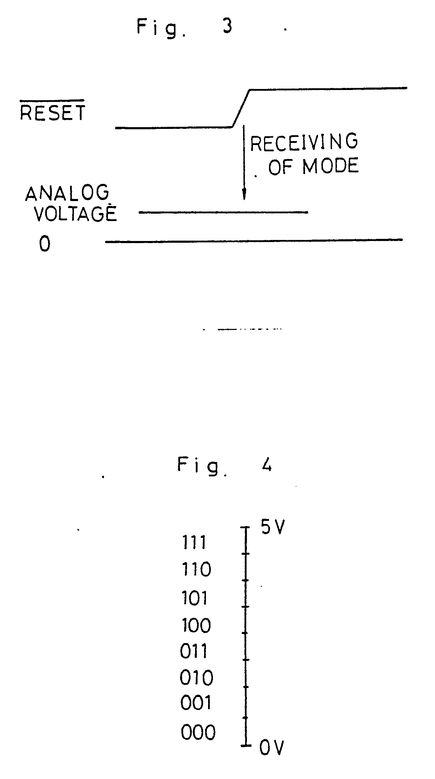

In parallel with the above operation, the reset input pin 17 is supplied with a signal of low level so as to initialize the processor portion 1. Upon completion of this operation, the signal of the reset input pin 17, having been at the low level, is shifted to a signal of high level as shown in Figure 3.

This shift is detected by the edge detector circuit 13, from which a write pulse is then supplied to the AND gate circuits 14. Then, the digital value stored in the digital value generator circuit 10, namely a parallel bit digital value for specifying the particular operation mode is/are loaded into the mode register 15. The digital value is supplied from the register 15 to the mode decoder 16 and is decoded by the latter. The decoded output signal is supplied to the processor portion 1. Thus, the processor portion is set in the particular operation mode.

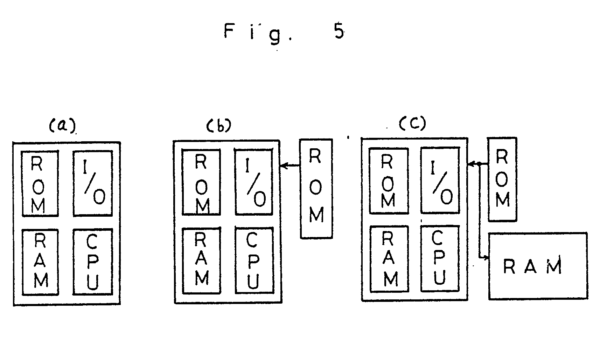

Such operation modes can be readily changed-over by providing that the signal, e.g. voltage, from the signal generator circuit means 3 is altered by replacing the voltage divider circuit 4, 5, adjusting it, etc., as illustrated in Figure 4, wherein (000), (001), . . . . etc. correspond to O V, 1 V, . . . . etc. in terms of multi-valued logic. Moreover, since such alterations do not require switching of input/output pins as in the prior art, input/output electrical characteristics are not changed. Further one pin suffices for operation mode selection, and the problem of the number of pins available, which as heretofore placed a restriction on the setting of operation modes, is avoided. In addition, the present invention does not suffer any limitative factor ascribable to the scale etc. of a microprocessor which has a plurality of operation modes.

Whilst, in the embodiment of the present invention illustrated in Fig. 2, the analog-to-digital converter circuit is of the sequential comparison type, the present invention it is not restricted to the use of such type of converter. A converter of high precision is not required unless the number of operation modes to be selected between is very large. Since the number of modes is usually ten or so, an analog-to-digital converter of 3—4 bits suffices, and such can be easily realized. Of course, it is possible to use one channel of an ordinary analog-to-digital converter.

As the circuit components which are to be externally mounted, two resistors for voltage division, as in Fig. 2, are sufficient in the simplest case. Dispersion in the resistance values of the resistors causes no real problem when a precision of only 3—4 bits is needed, and modes can be set merely by replacing the inexpensive resistor components.

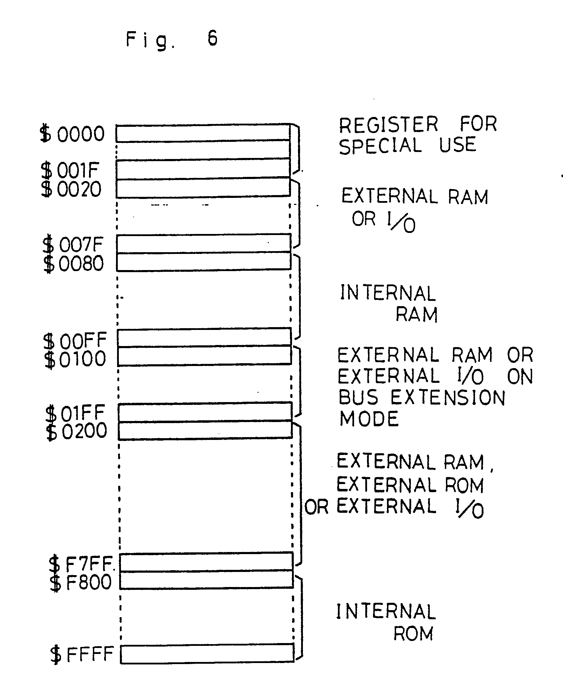

When external and internal ROMs and RAMs are jointly used as memory areas for storing programs or data as illustrated in Figure 5 (a), (b), (c), memory maps can be altered by changing set operation modes. The largest utilizable address space is given by the bus extension mode. Figure 6 shows a memory map diagram in which up to 65 kbytes can be accessed.

Referring to Figure 6, addresses $0020 to $007F access to external RAM or I/O circuit. An internal RAM is accessed by addresses $0080—$00FF. In a case where the user wants to use external RAM with the addresses of the internal RAM, an external RAM operation mode may be set. This method renders further 128 bytes effective as an external as an external RAM area. Addresses $0100—$01FF become valid in the bus extension mode. For example, an eight address line port has an extensity of 256 words. Upper bits unnecessary for the address lines can be used as I/O circuit inputs instead. The largest utilizable address space is given by the bus time-sharing extension mode. Addresses $0200—$F7FF can be used for external RAM, external ROM or I/O circuit. Also in this case, upper bits unnecessary for address lines can be utilized for I/O circuits.

To sum up, embodiments of the present invention can provide the followng beneficial results:

(1) A plurality of operation modes can be set by the use of only a single input pin.

(2) The input/output electrical characteristics of mode input pin circuitry are not changed.

(3) In performing the present invention, the scale etc. of a microprocessor form no limitative factor.

**Claims**

1. Operation mode setting circuity for a microprocessor (1) operable in any one of a plurality of operation modes, the operation mode setting circuitry comprising:

a terminal for receiving a multi-valued logic analog voltage (2) the voltage level of which serves for designating one of the said plurality of operation modes;

an analog to digital converter (6), connected to the said terminal for converting the voltage level of the analog voltage into a corresponding digital signal; and

a decoder means (14, 15, 16) connected to said analog to digital converter for decoding the digital signal and for generating therefrom a signal for setting the microprocessor in that one of the operation modes corresponding to the voltage level of the analog voltage.

2. Circuitry as claimed in claim 1, wherein the decoder means comprises

a register circuit (15) connectd to the analog to digital converter for storing the digital signal, and

a mode decoder circuit (16) connected to the register circuit for decoding said digital signal stored in the register circuit.

3. Circuitry as claimed in claim 2, wherein the decoder means further comprises an edge detector circuit (13) for detecting an edge of a reset signal for initializing the microprocessor, and at least one AND gate circuit (14), the or each AND gate circuit having a first input terminal, a second input terminal and an output terminal, the or each first input terminal being connected to a detection output of the detector circuit, the or each second input terminal being connected to the analog to digital converter, the or each output terminal being connected to the register circuit, the said digital signal being applied to the register circuit via the AND gate circuit or circuits when the microprocessor is initialized by the reset signal.

4. Circuitry as claimed in claim 1, 2 or 3 wherein the analog to digital converter is a sequential comparison type analog to digital converter.

5. Circuitry as claimed in claim 4, wherein the analog-to-digital converter comprises a voltage comparator (7) arranged for comparing the said analog voltage with a reference voltage, a voltage generator and selector (9) circuit which generates a plurality of voltages and selects one of those voltages for delivery to the voltage comparator as the reference voltage, a digital value generator circuit (10), providing a digital value, which when the comparison output of the voltage comparator indicates non-coincidence of the said analog voltage and the reference voltage, is operable to change the digital value and to provide a signal which causes the voltage generator and selector to select another of the said plurality of voltages as the reference voltage, and which, when the said comparision output indicates coincidence of the said analog voltage and the reference voltage, delivers the digital value as the said digital signal.

6. Circuitry as claimed in any preceding claim, wherein the digital signal comprises a plurality of bits.

7. Circuitry as claimed in any preceding claim, integrated in the same chip as the microprocessor, wherein the said terminal is a single input pin (2) of the chip dedicated for operation mode setting use.

8. A microprocessor chip incorporating circuitry as claimed in any preceding claim.

**Patentansprüche**

1. Operationsmodus-Setzschaltkreis für einen Mikroprozessor (1), der in irgendeiner von einer Vielzahl von Operationsmoden betreibbar ist, welche Operationsmodus-Setzschaltung umfaßt;

einen Anschluß zum Empfang einer mehrwertigen logischen Analogspannung (2), deren Spannungspegel zur Bestimmung einer der genannten Vielzahl von Operationsmoden dient;

einen Analog/Digital-Wandler (6), der mit dem genannten Anschluß zur Wandlung des Spannungspegels der Analogspannung in ein entsprechendes digitales Signal angeschlossen ist; und

eine Decodereinrichtung (14, 15, 16), die mit dem genannten Analog/Digital-Wandler verbunden ist, um das digitale Signal zu decodieren und daraus ein Signal zum Setzen des Mikroprozessors in denjenigen Operationsmodus zu erzeugen, welcher dem Spannungspegel der Analogspannung entspricht.

2. Schaltung nach Anspruch 1, bei welcher die Decodereinrichtung umfaßt:

eine Registerschaltung (15), die mit dem Analog/Digital-Wandler verbunden ist, zur Speicherung des digitalen Signals, und

eine Modendecoderschaltung (16), die mit der Registerschaltung verbunden ist, um das genannte digitale Signal, das in der Registerschaltung gespeichert ist, zu decodieren.

3. Schaltung nach Anspruch 2, bei welcher die Decodereinrichtung ferner eine Flankendetektorschaltung (13) umfaßt, zur Detektion der Flanke eines Rücksetzsignals zum Initialisieren des Mikroprozessors, und wenigstens eine UND-Torschaltung (14), wobei die oder jede UND-Torschaltung einen ersten Eingangsanschluß, einen zweiten Eingangsanschluß und einen Ausgangsanschluß hat, von denen oder jeder erste Eingangsanschluß mit einem Detektionsausgang der Detektorschaltung verbunden ist, der oder jeder zweite Einganganchluß mit dem Analog/Digital-Wandler verbunden ist, der oder jeder Ausgangsanschluß mit der Registerschaltung verbunden ist, das genannte digitale Signal der Registerschaltung über die UND-Torschaltung oder -schaltungen zugeführt wird, wenn der Mikroprozessor durch das Rücksetzsignal initialisiert ist.

4. Schaltung nach Anspruch 1, 2 oder 3, bei welcher der Analog/Digital-Wandler ein Analog/Digital-Wandler vom sequenziellen Vergleichstyp ist.

5. Schaltung nach Anspruch 4, bei welcher der Analog/Digital-Wandler einen Spannungskomparator (7) umfaßt, der zum Vergleich der genannten Analogspannung mit eiener Referenzspannung angeordnet ist, eine Spannungsgenerator- und Selektorschaltung (9), die eine Vielzahl von Spannungen generiert und eine von jenen Spannungen zur Lieferung an den Spannungsgenerator als Referenzspannung auswählt, eine Digitalwert-Generatorschaltung (10), die einem digitalen Wert liefert, der dann, wenn der vergleichsausgang des Spannungsgenerators eine Nichtkoinzidenz der genannten Analogspannung und der Referenzspannung anzeigt, betreibbar ist, um den digitalen Wert zu ändern und ein Signal zu liefern, welches verursacht, daß der Spannungsgenerator und -selektor eine andere der genannten Vielzahl von Spannungen als Referenzspannung wählt, und der, wenn der genannte Vergleichsausgang eine Koinzidenz der genannten Analogspannung der Referenzspannung anzeigt, den Digitalwert als das genannte difitale Signal liefert.

6. Schaltung nach einem der vorhergehenden Ansprüche, bei welcher das Digitalsignal eine Vielzahl von Bits umfaßt.

7. Schaltung nach einem der vorhergehenden Ansprüche, welche in demselben Chip wie der Mikroprozessor integriert ist, bei welcher der genannte Anschluß ein einziger Eingangsstift (2) des Chips ist, der für die Verwendung zur Operationsmodeneinstellung bestimmt ist.

8. Mikroprozessorchip mit einer Schaltung nach einem der vorhergehenden Ansprüche.

**Revendications**

1. Circuit de réglage de mode de fonctionnement pour un microprocesseur (1) pouvant être mis en fonctionnement dans n'importe quel mode d'un ensemble de modes de fonctionnement, le circuit de réglage de mode de fonctionnement comprenant:

une borne pour recevoir une tension analogique à plusieurs valeurs logiques (2) dont le niveau de tension sert à définir l'un de l'ensemble des modes de fonctionnement;

un convertisseur analogique-numérique (6) connecté à la borne pour convertir le niveau de tension de la tension analogique en un signal numérique correspondant; et

un moyen décodeur (14, 15, 16) connecté au convertisseur analogique-numérique pour décoder le signal numérique et pour engendrer à partir de celui-ci un signal pour régler le microprocesseur dans ledit mode des modes de fonctionnement correspondant au niveau de tension de la tension analogique.

2. Ciruit selon la revendication 1, dans lequel le moyen décodeur comprend;

un circuit à registre (15) connecté au convertisseur analogique-numérique pour mémoriser le signal numérique, et

un circuit décodeur de mode (16) connecté au circuit à registre pour décoder le signal numérique mémorisé dans le circuit à registre.

3. Circuit selon la revendication 2, dans lequel le moyen décodeur comprend en outre un circuit détecteur de bord (13) pour détecter un bord d'un signal de remise à zéro servant à l'initialisation du microprocesseur, et au moins un circuit à porte ET (14), le ou chaque circuit à porte ET comportant une première borne d'entrée, une seconde d'entrée et une borne de sortie, la ou chaque première borne d'entrée étant connectée à une sortie de détection du circuit détecteur, le ou chaque seconde borne d'entrée étant connectée au convertisseur analogique-numérique, la ou chaque borne de sortie étant connectée au circuit à registre, le signal numérique étant appliqué au circuit à registre par l'intermédiaire du circuit ou des circuits à porte ET quand le microprocesseur est initialisé par le signal de remise à zéro.

4. Circuit selon l'une quelconque des revendications 1 à 3, dans lequel le convertisseur analogique-numérique est un convertisseur analogique-numérique du type à comparaison séquentielle.

5. Circuit selon la revendication 4, dans lequel le convertisseur analogique-numérique comprend und comparateur de tensions (7) agencé pour comparer la tension analogique à une tension de référence, un circuit générateur et sélecteur de tension (9) qui engendre un ensemble de tensions et sélectionne l'une de ces tensions pour la fournir au comparateur de tension comme tension de référence, un circuit générateur de valeur numérique (10), fournissant une valeur numérique qui, lorsque le signal de comparision de sortie du comparateur de tensions indique une absence de coïncidence de la tension analogique et de la tension de référence, peut être mis en fonctionnement pour changer la valeur numérique et pout fournir un signal qui fait en sorte que le générateur et sélecteur de tension sélectionne une autre tension de l'ensemble des tensions comme tension de référence, et qui, lorsque le signal de comparaison de sortie indique une coïncidence de la tension analogique et de la tension de référence, fournit la valeur numérique comme signal numérique.

6. Circuit selon l'une quelconque des revendications 1 à 5, dans lequel le signal numérique comprend un ensemble de bits.

7. Circuit selon l'une quelconque des revendications 1 à 6, qui est intégré dans la même puce que le microprocesseur, dans lequel ladite borne est une seule broche d'entrée (2) de la puce réservée pour servir au réglage de mode de fonctionnement.

8. Puce de microprocesseur incorporant un circuit tel que revendiqué dans l'une quelconque des revendications 1 à 7.

Fig. 1 A

| 7 | 6 | 5 | 4 | 3 | 2 | 1 | 0 |
|---|---|---|---|---|---|---|---|
| PC 2 | PC 1 | PC 0 | I/04 | I/03 | I/02 | I/01 | I/00 |

Fig. 1B

TO
MICRO
PROCESSOR

RESET ← ... $V_{cc}$

PIN 8 → TO PERIPHERAL DEVICE / FROM CONTROL SIGNAL

PIN 9 → TO PERIPHERAL DEVICE / FROM CONTROL SIGNAL

PIN 10 → TO PERIPHERAL DEVICE / FROM CONTROL SIGNAL

Fig. 1C

IN/OUT ○

OUT/IN ○

CONTROL ○

| CONTROL | SWITCH |
|---------|--------|
| 0 | OFF |
| 1 | ON |

Fig. 2

Fig. 3

RESET

RECEIVING
. OF MODE

ANALOG
VOLTAGE

0

Fig. 4

5 V
111
110
101
100
011
010
001
000
0 V

Fig. 5

(a)

(b)

(c)

Fig. 6

| | | |
|---|---|---|
| $ 0000 | | REGISTER FOR SPECIAL USE |
| $ 001F | | |
| $ 0020 | | EXTERNAL RAM OR I/O |
| $ 007F | | |
| $ 0080 | | INTERNAL RAM |
| $ 00FF | | |
| $ 0100 | | EXTERNAL RAM OR EXTERNAL I/O ON BUS EXTENSION MODE |
| $ 01FF | | |
| $ 0200 | | EXTERNAL RAM, EXTERNAL ROM OR EXTERNAL I/O |
| $ F7FF | | |
| $ F800 | | INTERNAL ROM |
| $ FFFF | | |

5